(19) Europäisches Patentamt

European Patent Office

Office européen des brevets

(11) **EP 4 700 482 A1**

(12) **EUROPEAN PATENT APPLICATION**

(43) Date of publication:
**25.02.2026 Bulletin 2026/09**

(21) Application number: **24196201.8**

(22) Date of filing: **23.08.2024**

(51) International Patent Classification (IPC):
*G03F 7/20* (2006.01)      *H05G 2/00* (2006.01)

(52) Cooperative Patent Classification (CPC):
**G03F 7/70033; G03F 7/70175; H05G 2/003**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicants:
• **Carl Zeiss SMT GmbH**
  **73447 Oberkochen (DE)**
• **ASML Netherlands B.V.**
  **5504 DR Veldhoven (NL)**

(72) Inventors:
• **Harrison, Kramer Daniel**
  **5504 DR Veldhoven (NL)**
• **Van der Veen, Paul**
  **5504 DR Veldhoven (NL)**
• **Jurna, Martin**
  **5504 DR Veldhoven (NL)**
• **Kockerols, Jean**
  **5504 DR Veldhoven (NL)**

(74) Representative: **Rau, Schneck & Hübner**
**Patentanwälte Rechtsanwälte PartGmbB**
**Königstraße 2**
**90402 Nürnberg (DE)**

(54) **EUV COLLECTOR MIRROR AND APERTURE INSERT THEREFORE**

(57)      An EUV collector mirror (22) for a light source module has a collector surface with a reflection surface (23) for reflecting usable EUV light, which impinges on the reflection surface (23) from a source region to a subsequent EUV optics and an in an aperture (29) for pump light. The inner aperture (29) has an aperture surface area, which is smaller than 1.4 % of a surface area of the collector surface. Described is also an aperture insert (37) for insertion into a main aperture (36) of the EUV collector mirror (22), to reduce a size of an effective aperture for the pump light.

Fig. 8

EP 4 700 482 A1

**Description**

The present invention relates to an EUV collector mirror for a light source module, which may be used in an EUV projection exposure apparatus. The invention further relates to a light source module, an illumination system for an EUV projection exposure apparatus and a projection exposure apparatus comprising the EUV collector mirror. Further, the invention relates to an aperture insert for an EUV collector mirror.

An illumination optical unit with an EUV collector mirror is known from from US 2019/0094699 A1. Further EUV collector mirror embodiments are known from DE 10 2019 200 698 A1 and WO 2021/073813 A1.

It is an object of the present invention to improve a light source module for EUV light, in particular an EUV collector mirror therefor, and more specifically to improve EUV power output of the light source.

This object is achieved by an EUV collector mirror comprising the features specified in claim 1.

The EUV collector mirror has a collector surface having a reflection surface for reflecting usable EUV light, which impinges on the reflection surface from a source region to a subsequent EUV optics. The collector surface further comprises an inner aperture for the pump light. The inner aperture has an aperture surface area which is smaller than 1.4 % of the surface area of the collector surface. The aperture surface area may in particular be smaller than 1.3 %, in particular smaller than 1.2 %, in particular smaller than 1.1 %, in particular smaller than 1 %, in particular smaller than 0.9 %, of the surface area of the collector surface. The inventors have realized that small aperture surface areas are advantageous. Having a small aperture surface area reduces the amount of EUV light reaching the outside of the light source module via the inner aperture, thereby reducing thermal stress on components outside of the light source module, such as a pump light source and/or pump light optics, such as a pump light focusing unit. Moreover, since less EUV light escapes through the inner aperture, the EUV light output can be increased. In particular, decreasing the aperture surface area allows for an increase of the surface area of the reflection surface, leading to a better reflectance of usable EUV light, increasing the EUV light power.

For example, a gain in EUV light power may be up to about 7 %, in particular between 1.6 % and 2.9 %.

The collector surface in the sense of the present invention is to be understood as the surface of the EUV collector mirror, which faces a source region of the light source module. The collector surface in particular includes the reflection surface as well as the inner aperture. In that sense, the reflection surface and the inner aperture may be different surface sections of the collector surface. The collector surface may include further EUV collector mirror components, e.g. a purge nozzle surrounding the inner aperture for jetting purge fluids on the reflection surface.

The surface area of the collector surface, in particular the surface area of the reflection surface and of the inner aperture, may be determined based on the three dimensional shape of the EUV collector mirror. For example, the EUV collector mirror may have an ellipsoidal shape. The aperture surface area then may correspond to the area of the ellipsoidal surface section where the inner aperture is formed. In particular, the aperture surface area may be calculated in the same way as a corresponding surface section of the reflection surface of the, in particular ellipsoidal, EUV collector mirror, would be calculated.

The aperture surface area according to claim 2 has proven particularly advantageous. In particular, the aperture surface area allows for an increased EUV light output and, at the same time, sufficient pump light entering the light source module. In particular, one or more light beams of the pump light can pass the inner aperture, even if beam cross sections of different light beams do not overlap or are even spatially separated from each other, when passing the inner aperture. For example, the aperture surface may be between 0.53 % and 1.3 %, in particular between 0.53 % and 1.2 %, in particular between 0.53 % and 1.1 %, in particular between 0.53 % and 1.0 %, in particular between 0.53 % and 0.9 %, of the surface area of the collector surface.

An aperture diameter according to claim 3 ensures a sufficiently small aperture surface area. The aperture diameter preferably measures between 53 mm and 80 mm. Particularly preferable, it is smaller than 80 mm, in particular smaller than 75 mm, in particular smaller than 70 mm. For example, the inner aperture may be circular, so that the aperture diameter is the diameter of the circle. Also, other shapes of the inner aperture are possible. For example, the inner aperture may have an elliptical or oval aperture contour. The aperture diameter may be the diameter along a principle axis or main extension of the inner aperture. The aperture diameter further ensures that light beams of the pump light are not partially shaded or clipped by the inner aperture.

The aperture diameter is, in particular, the diameter of a projection of the inner aperture on a plane, which is perpendicular to an optical axis of the EUV collector mirror.

The EUV collector mirror may have a collector aperture, e.g. of about 0.650 m. The aperture diameter of the inner aperture may, for example, range from about 8.2 % to about 13.1 %, in particular from about 8.2 % to about 12,3 %, in particular from about 8.2 % to about 11,5 %, in particular from about 8.2 % to about 10,8 %, of the collector aperture. The aperture surface area of the inner aperture may, for example, range from about 2210 mm$^2$ to about 5696 mm$^2$, in particular from about 2210 mm$^2$ to about 5044 mm$^2$, in particular from about 2210 mm$^2$ to about 4431 mm$^2$, in particular from about 2210 mm$^2$ to about 3859 mm$^2$.

An aperture contour according to claim 4 is particularly advantageous. Adapting the aperture contour to a given beam cross section of one or more light beams of the pump light, in particular, ensures an effective reduction of the aperture surface area, without interfering or even blocking parts of the pump light.

The aperture contour is in particular the contour of a projection of the inner aperture to a plane, which is perpendicular to the optical axis of the EUV collector mirror.

For example, the beam cross section of the pump light may be circular. In that case, the inner aperture may have a circular aperture contour. The aperture diameter of the inner aperture may be chosen based on a diameter of the beam cross section. For example, the aperture may be slightly larger than the diameter of the beam cross section.

A non-circular aperture contour according to claim 5 advantageously allows an adaption of the inner aperture to non-circular beam cross section of the pump light. For example, the pump light may comprise different pump light beams, whose beam cross sections may be spatially separated when passing the inner aperture. For example, the aperture contour may have a twofold or even a onefold rotation symmetry. Particularly preferable, the aperture contour may be oval or egg-shaped. It is also possible that the aperture contour even further reflects the shape of two or more pump light beams, e.g. by following the beam contour of the pump light beams.

An EUV collector mirror according to claim 6 is flexibly and easily adaptable to different pump light configurations. In particular, the aperture insert may be used to retrofit or upgrade existing EUV collector mirrors, which have a large main aperture. This way, the EUV light output of existing EUV collector mirrors can be improved. Further, the pump light configuration, in particular its beam cross section, can be adapted, without requiring the exchange of the EUV collector mirror.

The advantages of the light source module according to claim 7 are those explained above with respect to the EUV collector mirror.

An obscuration structure according to claim 8 further increases the EUV light output. The inventors have realized that EUV light, which is reflected by the reflection surface, in particular in a surface area close to the inner aperture, may at least partially be blocked by existing obscuration structures. To remedy this effect, the shape and/or size of the obscuration structure is adapted to the inner aperture. For example, the shape, in particular contour, of the obscuration structure can correspond to an aperture contour of the inner aperture. Further, it is possible to decrease the size, in particular the diameter, of the obscuration structure in correspondence to the decrease of the size of the inner aperture, in particular in correspondence to the decrease of the aperture diameter.

The contour of the obscuration structure is in particular the contour of a projection of the obscuration structure to a plane, which is perpendicular to the optical axis of the EUV collector mirror.

An obscuration structure contour, which corresponds to the aperture contour, means in particular that the obscuration structure as well as the aperture contour have the same outer geometrical shape, in particular when projected to a plane, which is perpendicular to the optical axis of the EUV collector mirror. This means that the shapes of the contours coincide but not necessarily the respective sizes. The size of the obscuration bar b, in particular its diameter in one or more directions, may differ from that of the inner aperture.

Preferably, the shape and/or size of the obscuration structure is chosen in a way that EUV light being reflected by the reflection surface is not obscured by the obscuration structure. Based on the aperture diameter and/or the aperture contour of the inner aperture a maximum diameter of the obscuration structure can be determined, in particular in dependence of a position of the obscuration structure in relation to the source region. The diameter of the obscuration structure can be chosen smaller or equal to that maximum diameter. In particular, the obscuration structure is configured not to block any light path originating in the primary focus and being reflected by the reflection surface towards the intermediate focus.

At the same time, sufficient shielding of the subsequent EUV optics from pump light as well as heat dissipation can be considered. In particular, the obscuration structure should at least cover any pump light, which directly passes from the source region towards a source aperture of the light source module. In that regard, a solid angle of the obscuration structure as seen from the source region should at least coincide with the solid angle of the source aperture. Particularly preferable, the size of the obscuration structure is chosen to be the maximum diameter, ensuring high EUV light output, reliable pump light shielding and good heat dissipation.

The inventors have realized that decreasing the size of the obscuration structure, in particular adapting the shape and/or size of the obscuration structure to an inner aperture of the EUV collector mirror, allows for an increase in the EUV light output, without necessarily requiring a decrease in the inner aperture size, in particular a decrease in the aperture surface area. As such, the decrease of the obscuration structure, in particular to or below the maximum diameter discussed above, is an independent aspect of the invention disclosed herein.

A light source module according to claim 9 allows to combine several pump light sources without increasing the beam cross section of the pump light. As such, the inner aperture, in particular the aperture surface area, can be minimized even for scenarios where two or more pump light sources are used, e.g. to independently generate different pulses of the pump light, in particular a pre-pulse, a rarefaction pulse and/or a main pulse.

The advantages of an illumination system according to claim 10 and a projection exposure apparatus according to claim 11 are those, which previously were discussed with respect to the EUV collector mirror and the light source module.

The above-stated object is also solved by an aperture insert for an EUV collector mirror with the features of claim 12.

The aperture insert comprises a base body with an inner aperture for the pump light and is configured to be inserted into a main aperture of a EUV collector mirror, thereby reducing the size of an effective aperture for the pump light. The aperture insert allows to achieve the above-stated advantages by inserting the aperture insert in known collector mirrors, without requiring an exchange of the entire EUV collector mirror.

The aperture insert may preferably be used in an EUV collector mirror as described above. The aperture insert may comprise one or more of the features discussed with regard to the inner aperture of the EUV collector mirror, in particular with regard to aperture surface area and/or aperture diameter and/or aperture contour of the inner aperture.

An aperture insert according to claim 13 is particularly advantageous with regard to the increase of the EUV light output. The mirror segment 44 may be realised by an EUV coating being applied to the base body. It is also possible that the mirror segment is realised by a mirror component, which is separate from the base body. For example a mirror segment may comprise a mirror body, which is placed on, in particular connected to, in particular bolted to, the base body. The mirror body may comprise reflective properties. Preferably, an EUV coating is applied to the mirror body. The mirror body allows for a higher precision of the reflection surface, in particular the mirror body can be optimized with respect to material properties and/or surface properties to its functionality.

The mirror segment, in particular the mirror component, may be circumferentially arranged around the inner aperture, in particular around a cone structure of the inner aperture. For example, the mirror segment may be ring-shaped.

An aperture insert according to claim 14 enables a high conversion efficiency from the pump light energy into usable EUV light energy. The pump light grating may be formed directly on the base body, in particular in a region of an EUV coating. The pump light grating may, preferably, be part of a mirror segment, in particular a mirror component, of the aperture insert.

An aperture insert according to claim 15 allows for a stable and pre-defined alignment of the aperture insert. In particular, the aperture insert can be aligned in dependence of a beam cross section of one or more light beams of the pump light. The alignment means are particularly suitable in a case where the inner aperture of the aperture insert has a non-circular, in particular an oval or egg-shaped, aperture contour. This way, the orientation of the aperture contour with regard to a beam cross section of the pump light can be flexibly and reliably adjusted.

An aperture insert according to claim 16 allows to purge debris and other contaminations from the reflection surface and/or from an EUV coating of the aperture insert itself. This ensures reliable and stable operation conditions.

An aperture insert according to claim 17 has good heat dissipation properties. Heat can be effectively dissipated away from the aperture insert, preventing damage or other influences on the aperture insert.

An aperture insert according to claim 18 allows for a flexible adaption of the aperture contour of the inner aperture independent of a contour of the main aperture. In particular, the EUV collector mirror can be flexibly adapted to changing pump light configurations. Moreover, the usable surface area for an EUV coating of the aperture insert is increased.

The above-stated problem is also solved by a light source module for EUV light with the features set out in independent claim 19. It has been realized that EUV power output is reduced by EUV light, which may be blocked by the obscuration structure of the light source module. While the obscuration structure is required to shield the subsequent EUV optics from pump light, it is desirable that most of the EUV light, which is produced in the source region, can be used for illumination. It has been found that due to the fact the EUV light is generated in the source region around the primary focus, the obscuration structure can be configured, in particular shaped and/or dimensioned, so that any light originating from the primary focus and being reflected by the EUV collector mirror can pass the obscuration structure and at the same time the EUV optics are securely shielded from pump light.

Having the obscuration structure configured in that way, the amount of EUV light being blocked is minimized. In particular, only the mounting rod, which cannot be obliterated, shields some fraction of the EUV light.

The mounting rod may, for example, mount the obscuration structure to a housing of the light source module.

It has in particular be found that the configuration of the obscuration structure not to block EUV light leads to an increase of the EUV power output in comparison to previously known light source modules without changing further parameters and/or components of the light source module. Particularly preferable, the configuration of the obscuration structure can be combined with one or more of the features described above with respect to the inner aperture and/or an inner aperture insert.

The light source module according to claim 20 can preferably be combined with an inner aperture of reduced size and/or with non-circular contour. The inner aperture and the obscuration structure are adapted to each other, thereby optimizing the EUV power output.

An obscuration structure contour, which corresponds to the aperture contour, means in particular that the obscuration structure as well as the aperture contour have the same outer geometrical shape, in particular when projected to a plane, which is perpendicular to the optical axis of the EUV collector mirror. This means that the shapes of the contours coincide but not necessarily the respective sizes. The size of the obscuration bar b, in particular its diameter in one or more directions, may differ from that of the inner aperture.

The light source module of claim 21 allows for exploiting the benefits of specific aperture contours without blocking EUV light.

The light source module according to claim 22 allows to adapt the obscuration structure to different beam cross sections of the pump light beams. In particular, the obscuration structure can have an oval or egg-shaped contour.

Particularly preferable, the obscuration structure as well as the inner aperture have corresponding non-circular contours, which are in particular aligned with respect to each other.

The light source module according to claim 23 allows to precisely define the diameter of the obscuration structure in dependence of the reflection surface aperture diameter D. Given a specific shape and size of the inner aperture, in particular of the reflection surface aperture diameter D, an appropriate diameter B of the obscuration structure can be chosen.

The diameter B of the obscuration structure is in particular measured in a plane perpendicular to the optical axis of the EUV collector mirror.

The diameter B of the obscuration structure can be independently chosen for any direction perpendicular to the optical axis of the EUV collector mirror, e.g. if the inner aperture has different reflection surface aperture diameters D in different directions, e.g. due to an oval-shaped or egg-shaped aperture contour. It is also possible that the diameter B of the obscuration structure may be the same in any direction perpendicular to the optical axis of the EUV collector mirror, e.g. in case of a circular-shaped aperture contour and/or obscuration structure contour.

Preferably, the obscuration structure is configured in a way that at least pump light, which directly passes from the source region towards a source aperture of the light source module, is blocked by the obscuration structure. In that regard, the obscuration structure may have a minimum size so that the corresponding solid angle as seen from the source region is at least as large as the solid angle of the source aperture.

The light source module according to claim 24 is particularly reliable. Choosing the diameter B of the obscuration structure to be at least $0.75 \cdot B_{max}$ ensures a reliable blocking of pump light and a good heat dissipation. Moreover, an optimized EUV power output can be achieved. The minimum diameter $B_{min}$ may in particular be $0,85 \cdot B_{max}$, in particular $0,9 \cdot B_{max}$, preferably $0,95 \cdot B_{max}$. Particularly preferable, the diameter B may be chosen to be about the maximum diameter $B_{max}$.

Exemplary embodiments of the invention are explained in greater detail below with reference to the drawing. In said drawing shows:

Figure 1          schematically a projection exposure apparatus for EUV microlithography;

Figure 2          in a meridional section an EUV light source module,

Figure 3          a detail III of the EUV lights source module of Figure 2,

Figure 4A to 4C   different exemplary configurations of an inner aperture of the EUV collector mirror and a correspondingly adapted obscuration structure of the EUV light source module,

Figure 5          a power of the EUV light in dependence of an inner aperture in an EUV collector mirror of the EUV light source module,

Figure 6A to 6C   an advantageous diameter of an obscuration structure of the EUV light source module in dependence of the inner aperture diameter of the inner aperture of the EUV collector mirror,

Figure 7          a further exemplary example of a configuration of an inner aperture of an EUV collector mirror,

Figure 8          an exemplary embodiment of an EUV collector mirror with an aperture insert for reducing the size of an effective aperture for the pump light,

Figure 9          a further exemplary embodiment of an EUV collector mirror with an aperture insert, and

Figure 10         a perspective of an exemplary embodiment of an aperture insert, which may, for example, be used in the EUV collector mirror of Figure 8.

A projection exposure apparatus 1 for microlithography comprises a light source module 2 for EUV illumination light and/or imaging light 3, which will be explained in yet more detail below. Such light source module 2 also is denoted as a source collector module. A light source of the light source module 2 is an EUV light source, which produces light in a wavelength range, which is concentrated, for example, between 5 nm and 30 nm, in particular between 5 nm and 15 nm. The illumination light and/or imaging light 3 is also referred to as used EUV light below.

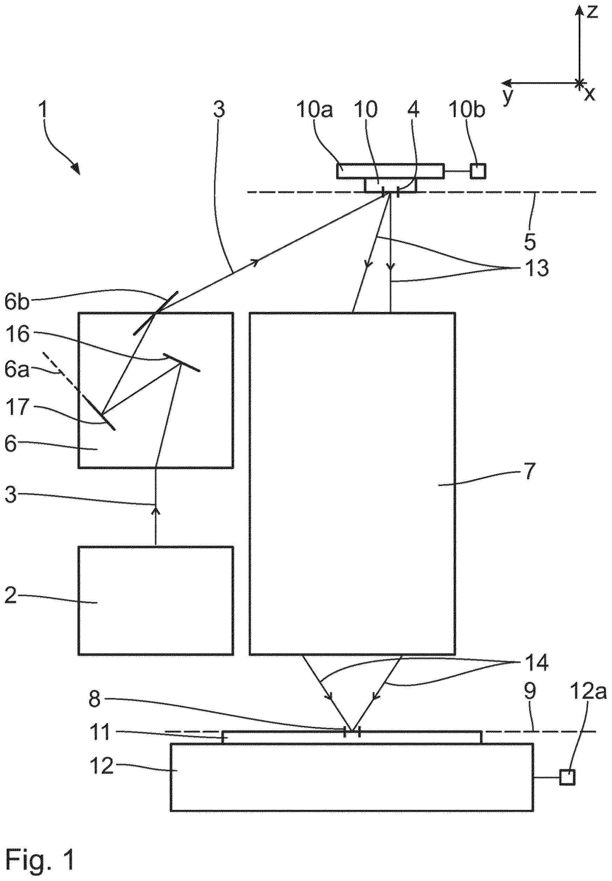

In particular, the EUV light source may be a light source with a used EUV wavelength of 13.5 nm or a light source with a used EUV wavelength of 6.9 nm or 7 nm. Other used EUV wavelengths are also possible. A beam path of the illumination light 3 is depicted very schematically in Figure 1.

An illumination optical unit 6 serves to guide the illumination light 3 from the light source to an object field 4 in an object plane 5. The light source module 2 together with the illumination optical unit 6 may form an illumination system of the projection exposure apparatus 1.

The exemplarily shown illumination optical unit 6 comprises a field facet mirror 16 depicted very schematically in Figure 1 and a pupil facet mirror 17 disposed downstream in the beam path of the illumination light 3 and likewise depicted very schematically. A field-forming mirror 6b for grazing incidence (GI mirror; grazing incidence mirror) is arranged in the beam path of the illumination light 3 between the pupil facet mirror PF, which is arranged in a pupil plane 6a of the illumination optical unit, and the object field 4. Such a GI mirror 6b is not mandatory.

Pupil facets (not depicted in any more detail) of the pupil facet mirror 17 are part of a transfer optical unit, which transfer, and in particular image, field facets (likewise not depicted) of the field facet mirror 16 into the object field 4 in a manner superposed on one another. An embodiment known from the prior art may be used for the field facet mirror 16 on the one hand and the pupil facet mirror 17 on the other hand.

By way of example, such an illumination optical unit 6 is known from DE 10 2009 045 096 A1. The illumination optical unit 6 may, e.g., be in form of a so called fly's eye condenser. It is also possible to use other setups for the illumination optical unit 6, in particular based on MEMS-optics.

Using a projection optical unit or imaging optical unit 7, the object field 4 is imaged into an image field 8 in an image plane 9 with a predetermined reduction scale. Projection optical units which may be used to this end are known from e.g. DE 10 2012 202 675 A1.

In order to facilitate the description of the projection exposure apparatus 1 and the various embodiments of the projection optical unit 7, a Cartesian xyz-coordinate system is indicated in the drawing, from which system the respective positional relationship of the components illustrated in the figures is evident. In Figure 1, the x-direction runs perpendicular to the plane of the drawing into the latter. The y-direction extends to the left in Figure 1 and the z-direction extends upward in Figure 1. The object plane 5 extends parallel to the xy-plane.

The object field 4 and the image field 8 are rectangular. Alternatively, it is also possible for the object field 4 and the image field 8 to have a bent or curved embodiment, that is to say, in particular, a partial ring shape. The object field 4 and the image field 8 have an x/y-aspect ratio of greater than 1. Therefore, the object field 4 has a longer object field dimension in the x-direction and a shorter object field dimension in the y-direction. These object field dimensions extend along the field coordinates x and y.

Any one of the exemplary embodiments known from the prior art may be used for the projection optical unit 7. What is imaged in this case as an object is a portion of a reflection mask 10, also referred to as reticle, coinciding with the object field 4. The reticle 10 is carried by a reticle holder 10a. The reticle holder 10a is displaced by a reticle displacement drive 10b.

The imaging by way of the projection optical unit 7 is implemented on the surface of a substrate 11 in the form of a wafer, which is carried by a substrate holder 12. The substrate holder 12 is displaced by a wafer or substrate displacement drive 12a.

Figure 1 schematically illustrates, between the reticle 10 and the projection optical unit 7, a ray beam 13 of the illumination light 3 that enters into said projection optical unit and, between the projection optical unit 7 and the substrate 11, a ray beam 14 of the illumination light 3 that emerges from the projection optical unit 7. An image field-side numerical aperture (NA) of the projection optical unit 7 is not reproduced to scale in Figure 1.

The projection exposure apparatus 1 is of the scanner type. Both the reticle 10 and the substrate 11 are scanned in the y-direction during the operation of the projection exposure apparatus 1. A stepper type of the projection exposure apparatus 1, in which a stepwise displacement of the reticle 10 and of the substrate 11 in the y-direction is effected between individual exposures of the substrate 11, is also possible. These displacements are effected synchronously to one another by an appropriate actuation of the displacement drives 10b and 12a.

An exemplary embodiment of the light source module 2 is depicted in Fig-ures 2 and 3. The light source module 2 comprises a source housing 20.

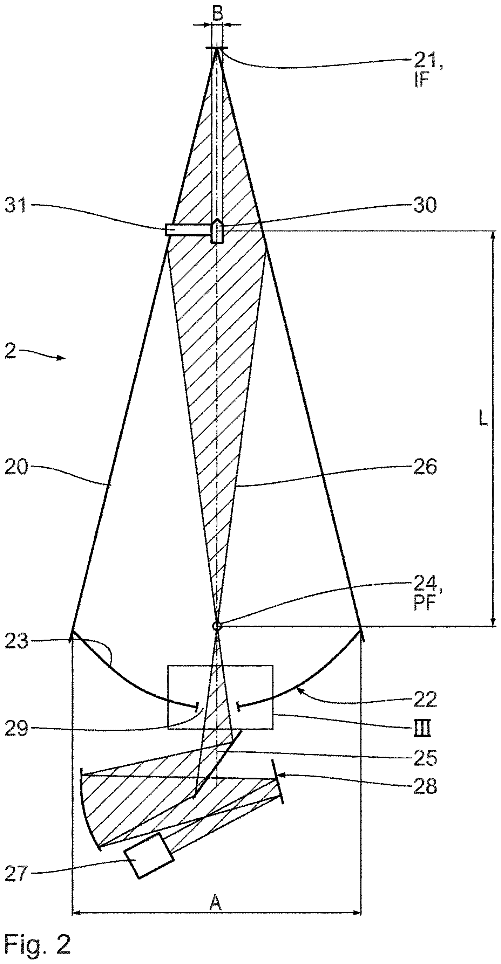

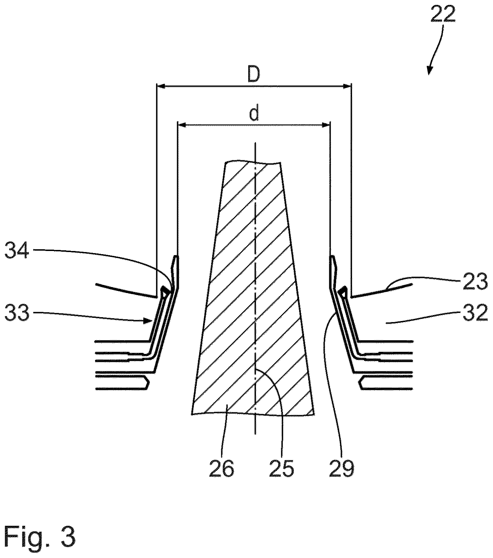

The source housing comprises a source aperture 21, through which usable EUV light (not shown in Figures 2 and 3) exits the light source module 2 towards the illumination optical unit 6. In the scale of Figure 2, source aperture 21 is not visible in detail. An exemplary radius of the source aperture 21 may be 3,25 mm.1

Opposite to the source aperture 21, an EUV collector mirror 22 is positioned. EUV collector mirror 22 serves to reflect the EUV illumination light pinching on a reflection surface 23 of the EUV collector mirror 22 from a source region 24 to the subsequent illumination optical unit 6 via the source aperture 21. To this end, the reflection surface 23 has an ellipsoidal shape, which is rotationally symmetric with respect to an optical axis 25. The reflection surface 23 of the EUV collector mirror 22 has a primary focus PF and an intermediate focus IF. The source region 24 is arranged in the region of the primary focus PF. The source aperture 21 is arranged in the region of the intermediate focus IF. The intermediate focus IF serves to discriminate the usable EUV elimination light 3 from other wavelengths and also from debris.

The reflection surface 23 may comprise an EUV coating for reflecting EUV illumination light 3, which impinges on the reflection surface 23. Exemplary EUV coatings are described in WO 2014/108 256 A1 and WO 2013/045 311 A1.

EUV illumination light 3 is generated by irradiating a pump light 26 on a tin droplet in the source region 24. Figures 2 und 3 show an exemplary optical path of pump light 26.

Pump light 26 is generated by a pump light source 27, schematically depicted in Figure 2. The pump light 26 is pulsed. The pump light source 27 may be MOPA (master oscillator power amplifier) laser source.

The pump light 26 may comprise several different pulses, in particular a pre-pulse, a rarefaction pulse and/or a main pulse. Different types of pulses may be generated by one or more laser sources of the pump light source 27. For example, pump light source 27 may comprise one or more $CO_2$ laser sources producing pump light having a wavelength around 10 $\mu$m, e.g. a pump light wavelength of 10.6 $\mu$m and/or 10.2 $\mu$m. Alternatively, the pump light source 27 may comprise one or more Nd-based solid state laser sources, e.g. a Nd:YAG laser producing a pump light wavelength around 1 $\mu$m, e.g. a pump light wavelength of 1.064 $\mu$m. The wavelength of the pump light 26 deviates from the wavelength of the EUV illumination light 3, in particular from the wavelength of the usable EUV light.

A pump light focusing unit 28 is used to focus pump light 26 on the source region 24. Pump light 26 impinges on a tin droplet arranged in the source region 24 to produce the illumination light 3, the letter not being shown in Figure 2. The optical paths of the pump light 22 from the pump light source 27 via the pump light focusing unit 28 to the source region 24 and beyond are only schematically depicted in Figure 2. In particular, Figure 2 shows only one possible beam configuration of the pump light 26, which is concentric with the optical axis 25. In other variants, the pump light may comprise different beams, in particular produced by different pump light source lasers, which may be coaxial to each other and to the optical axis 25 or be spatially separated from each other, e.g. by being irradiated on the source region 24 from different sides of and/or different angles to the optical axis 25.

Part of the pump light 26 impinging upon the tin droplet is absorbed by the tin droplet. Another part of the impinging pump light 26 is reflected from the tin droplet or passes towards the source aperture 21. In Figure 2, parts of the pump light 26, passing towards the source aperture 21 are shown. Reflected parts from the pump light 26, which are not depicted in Figure 2, impinge upon the reflection surface 23 of the EUV collector mirror 22 over a wide area thereof. In order to increase the amount of usable pump light 26, the reflection surface 23 may comprise a pump light grating structure for reflecting the pump light 26. An exemplary pump light grating structure is known from WO 2021/073 813 A1.

The EUV collector mirror 22 has a collector surface facing the source region 24. The collector surface comprises the reflection surface 23 as well as an inner aperture 29, through which the pump light 26 passes the EUV collector mirror 22. The inner aperture 29 is concentric to the optical axis 25 and will be described in greater detail below.

Parts of the pump light 26 pass the source region 24 towards the source aperture 21. The light source module 2 comprises an obscuration structure 30, arranged between the primary focus PF and the source aperture 21. The obscuration structure 30 blocks pump light 25 passing the source region 24 from exiting the source aperture 21. The obscuration structure 30 is also referred to as horizontal obscuration bar (or short: HO-bar). The obscuration structure 30 is placed at a distance L along the optical axis 25 from the primary focus PF. The obscuration structure 30 has a diameter B. The obscuration structure 30 is mounted to the source housing 20 via mounting rod 31.

Figure 3 schematically depicts an enlarged part of the EUV collector mirror 22 around the inner aperture 29. The EUV collector mirror comprises a collector substrate 32, on which the reflection surface 23 is formed, e.g. by an EUV coating. The inner aperture 29 is formed as a through hole through the collector substrate 32 and the reflection surface 23.

The inner aperture 29 has an aperture diameter d defining a free opening for the pump light 26. The inner aperture 29 may also be characterized by a reflection surface aperture diameter D, which measures the region in which the reflection surface 23 is interrupted due to the inner aperture 29. In many embodiments, e.g. if the inner aperture is formed directly in the reflection surface, the aperture diameter d and the reflection surface aperture diameter D may coincide. It is also possible, as shown exemplarily in Fig-ure 3, that the aperture diameter d and the reflection surface aperture diameter D differ, in particular due to edge effects of an EUV coating of the reflection surface 23 and/or further components of the EUV collector mirror 22. In the shown embodiment, the EUV collector mirror 22 comprises a purging system 33 for purging the reflection surface 23 with a purge fluid, in particular with $H_2$ gas. For that purpose, a cone-shaped purging nozzle 34 is arranged along the edge of the inner aperture 29 for jetting purge fluids along the reflection surface 23. In such cases, the reflection surface aperture diameter D may be larger than the aperture diameter d by an offset which is essentially determined by the purging nozzle 34. For example, the cone-shaped purging nozzle 34 may have a radial extension of about 10 mm, leading to an offset of about 20 mm between the two diameter measures. In some cases, the offset may be further increased by edge effects of the EUV coating.

The inner aperture 29 is adapted in size and/or shape so that the surface area of the collector surface, which may be used as reflection surface 23, is increased. Increasing the reflection surface 23 leads to a better reflection of EUV light towards the illumination optics unit 6. As such, the power output of the light source module is improved. The light source module 2 outputs more EUV light, in particular more EUV light power, for the lithography process.

Tests have shown that the usable EUV light output can be significantly improved, when an aperture surface of the inner aperture 29 is smaller than 1.4 % of a surface area of the collector surface. To optimize the EUV light reflection, the aperture surface area could be further increased, which, however, may hinder the passage of the pump light. Preferably, the aperture surface area is between 0.53 % and 1.4 % of the surface area of the collector surface. These portions of the collector surface for the inner aperture 29 have been proven to be particularly suitable for optimizing EUV light reflection and passage of the pump light at the same time. In that regard, the collector surface is defined as the surface of the EUV collector mirror 22, which faces the source region 24, including the reflection surface 23 and the inner aperture 29. The aperture surface area is the area of the through hole, through which the pump light 26 can pass.

The EUV collector mirror 22 has a collector aperture A. The aperture diameter d of the inner aperture 21 may, preferably, range from 8.2 % to 13.1 % of the collector aperture A. For example, the collector aperture A may be 0.650 m. A surface area of the collector surface including the inner aperture 29 in this case is 0.416 m$^2$. The aperture surface area of the inner aperture 22, may range from about 2210 mm$^2$ to about 5696 mm$^2$.

Decreasing the aperture surface area of the inner aperture 22 has the further advantage that less EUV light exits the light source module 2 through the inner aperture 29, leading to reduced heat stress on the pump light focusing unit 28.

In order to achieve a small inner aperture surface area, the aperture diameter d and with that the reflection surface aperture diameter D may be decreased.

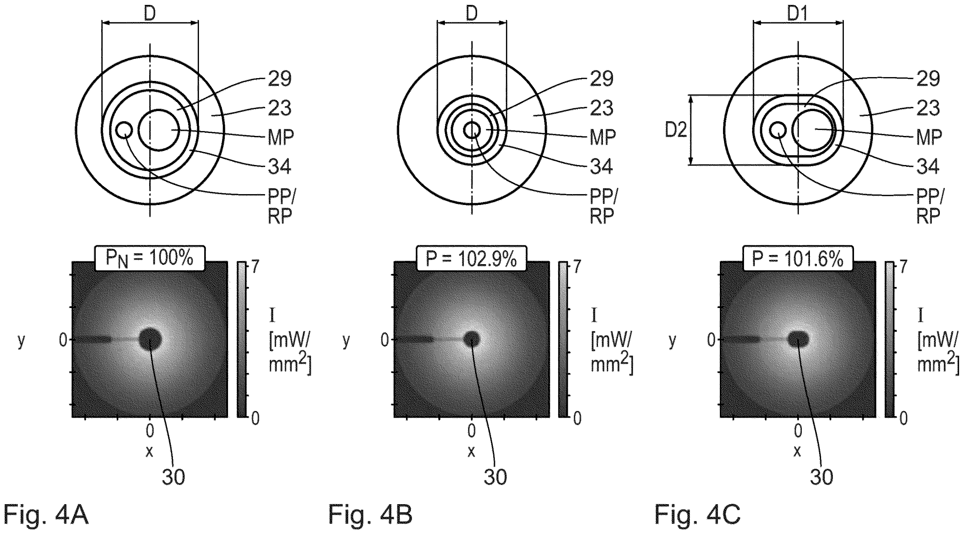

For example, the inner aperture 29 may have a circular aperture contour. An exemplary design of an inner aperture 29 of the EUV collector mirror 22 is shown in the upper part of Figure 4A. The lower part of Figure 4A shows the far field distribution of irradiance I of the EUV light. The pump light 26 comprises two separate beams for, on the one hand, the main pulse MP and, on the other hand, the pre-pulse PP and/or the rarefaction pulse RP. The main pulse MP and the pulses PP/RP pass the inner aperture 29 with a lateral offset. In the design according to the prior art (current design CD), the reflection surface aperture diameter D is about 107.5 mm and the diameter B of the obscuration structure B is 28.6 mm at L = 926 mm. The irradiance I shown in Figure 4A is based on the current design CD of the inner aperture 29 as well as the obscuration structure 30. The resulting EUV power $P_N$, referred to as nominal power $P_N$, is the reference point for the following analysis. In the far field distribution of the irradiance I, the obscuring effect of the obscuration structure can be seen.

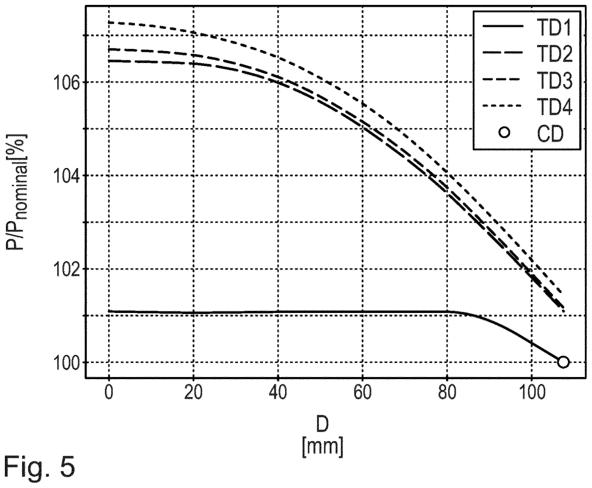

Figure 5 shows an analysis of the EUV power P at intermediate focus IF in relation to the nominal power $P_N$ as a function of the reflection surface aperture diameter D. The current design CD with nominal power $P_N$ is shown as a dot.

In a first test design TD1, the reflection surface aperture diameter D has been decreased, resulting in an increase of the EUV power P of about 1 %. As can be seen from Figure 5, however, the increase in EUV power P saturates for reflection surface aperture diameters D below 80 mm. While decreasing the reflection surface aperture diameter D increases the reflection surface, it was found that large parts of EUV light reflected close to the reduced inner aperture 29 may be obscured by the obscuration structure 30.

In further test designs TD2, TD3 and TD4, the obscuration structure 30 has been adapted.

In test design TD2, the diameter B of the obscuration structure 30 has been reduced by a factor of 4.

In test design TD3, the size of the obscuration structure 30 has been adapted so that its solid angle, as seen from primary focus PF, matches that of the source aperture 21. This is the minimum size, at which the obscuration structure 30 covers the pump light 26, which directly passes towards the source aperture 21. For example, a solid angle of the source aperture 21 as seen from primary focus PF may be about $1.859 \cdot 10^{-5}$ sr.

In test design TD4, the obscuration structure 30 has been completely removed. As can be seen from Figure 5, reducing the size of the obscuration structure 30 allows for a further increase of the EUV power P with decreasing reflection surface aperture diameter D.

A further finding of Figure 5 is that the EUV power P can be increased by decreasing the size of the obscuration structure, without decreasing the reflection surface aperture diameter D. As such, decreasing the size of the obscuration structure 30 is an independent aspect of the inventive technology described herein.

While decreasing the reflection surface aperture diameter D increases the reflection surface, decreasing the inner aperture 29 too far may interfere with or block the pump light 26. It has been found, that the aperture diameter d can particularly advantageously be chosen between 53 mm and 85 mm, in particular between 53 mm and 80 mm. The aperture diameter d is preferably smaller than 80 mm, in particular smaller than 75 mm, in particular smaller than 70 mm. Preferred ranges of the reflection surface aperture diameter D can be obtained based on the ranges of the aperture diameter d and the offset between the aperture diameter d and the reflection surface aperture diameter D, which, e.g., may be about 20 mm.

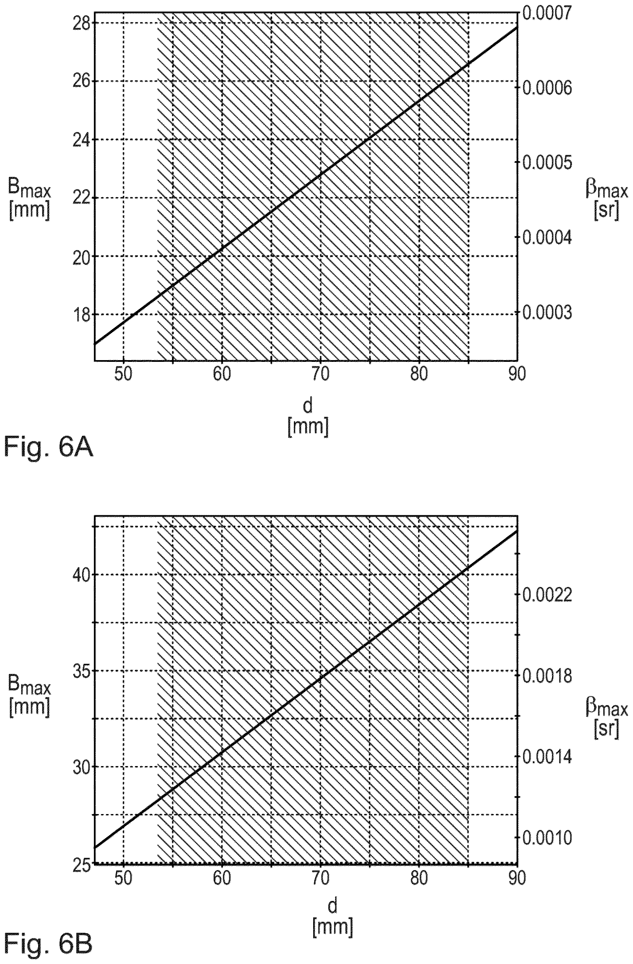

In Figures 6A to 6C, the effect of the size of the obscuration structure 30, in particular its diameter B is further analyzed. Figure 6A shows a diameter $B_{max}$ and a corresponding solid angle $\beta_{max}$, as seen from the primary focus PF, as a function of the aperture diameter d. The curve for the diameter $B_{max}$ and the solid angle $\beta_{max}$, respectively, reflects a size of the obscuration structure 30, at which clipping of the EUV light, which is reflected from the reflection surface 23 close to the inner aperture 29, occurs. As such, the diameter $B_{max}$ corresponds to the maximum diameter of a, in particular circular, obscuration structure 30, at which an increase in the EUV power P due to the reduced inner aperture size is not obscured by the obscuration structure 30. At or below $B_{max}$ ($\beta_{max}$), the obscuration structure 30 does not block any light path originating in the primary focus PF and being reflected by the reflection surface 23 towards the intermediate focus IF.

Figure 6A shows the exemplary situation, in which the obscuration structure 30 is placed at a distance L = 950 mm from the primary focus PF. Figure 6B shows the same graph for an obscuration structure at a distance L = 750 mm from primary focus PF. Of course, the given distances L are only exemplary. Other distances L are also possible.

Figures 6A and 6B highlight the range of particularly preferable physical hole diameters d between 53 mm and 85 mm as dashed area. Based on the respective analysis, it is possible to choose a suitable diameter B of the obscuration structure 30 for a given dimension of the inner aperture 29. In particular, a diameter B and/or a solid angle β can be chosen close to the respective maximum value, which does not lead to EUV light clipping. This way, a too strong reduction in size of the obscuration structure 30 is avoided. Too strongly reduce the size of the obscuration structure 30 may impair the shielding properties with regard to the pump light 26. Further, choosing a larger size of the obscuration structure 30 improves heat dissipation. As such, the dimensions of the obscuration bar can be chosen based on the respective position of the obscuration structure 30, in particular its distance L, and the size of the inner aperture 29.

For an ellipsoidal EUV collector mirror 22, having a semi-major axis a and a semi-minor axis b, the maximum diameter $B_{max}$ can be determined as a function of the reflection surface aperture diameter D by

$$B_{max}(D) = D \frac{2\,c - L}{c + a\sqrt{1 - D^2/(4b^2)}},$$

wherein c is the focus location of the primary focus PF along the optical axis 25 measured from the ellipse center:

$$c = \sqrt{a^2 - b^2}$$

. For a given reflection surface aperture diameter D, the diameter B of the obscuration structure can be chosen to be: $B \le B_{max}(D)$.

Preferably, B is chosen close to $B_{max}$, in particular $0{,}75\,B_{max}(D) \le B \le B_{max}(D)$, in particular $0{,}85\,B_{max}(D) \le B \le B_{max}(D)$, in particular $0{,}9\,B_{max}(D) \le B \le B_{max}(D)$.

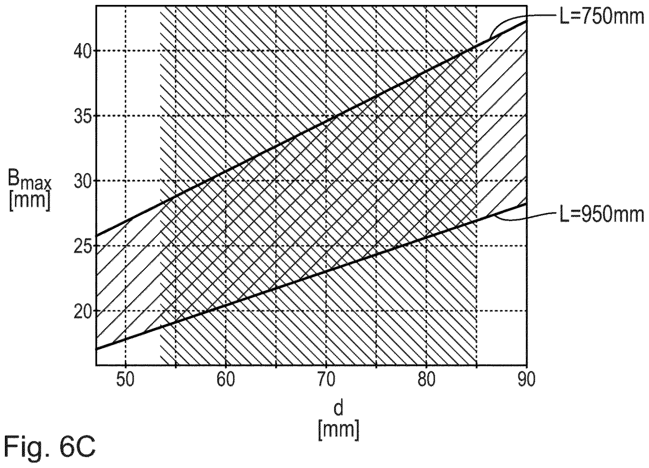

Figure 6C depicts a possible range for the maximum diameter $B_{max}$ of the obscuration structure 30 as a function of the physical hole parameter d for a range of exemplary distances L between L = 750 mm and L = 950 mm.

Figure 4B shows a particularly preferable embodiment of a light source module 2 with a reduced aperture surface of the inner aperture 29. The laser beams for the main pulse MP and the pre-pulse PP as well as the rarefaction pulse RP are aligned to coaxially pass through the inner aperture 29 of the EUV collector mirror. This reduces the beam cross section of the pump light 26 significantly, allowing to significantly reduce the aperture diameter d and the reflection surface aperture diameter D. In the shown embodiment, the reflection surface aperture diameter D is 75 mm, resulting in a significant reduction with regard to the current design (cf. Figure 4A).

The diameter B of the obscuration structure 30 has been reduced with regard to the current design. In the embodiment of Figure 4B, the diameter B of the obscuration structure 30 has been reduced by the same factor as the reflection surface aperture diameter D with regard to the current design. The resulting irradiance I is depicted in the lower part of Figure 4B. The resulting EUV power P is 102.9 % of the nominal power $P_N$. The increase is achieved by changing the diameter B and the reflection surface aperture diameter D/the aperture diameter d, whereas all other process parameters are kept unaltered. The exact increase of EUV power P may depend on further process parameters, such as the specific plasma composition.

Additionally or alternatively to reducing the aperture diameter d and with that the reflection surface aperture diameter D, it is also possible to change the aperture contour of the inner aperture 29. In particular, the aperture contour can be adapted to a beam cross section of one or more light beams of the pump light 26.

In Figure 4C an exemplary embodiment with an adapted aperture contour of the inner aperture 29 is shown. Different light beams for the main pulse MP and the pre-pulse PP/rarefaction pulse RP are spatially separated when passing the inner aperture 29. The aperture contour of the aperture 29 is adapted to better reflect the resulting beam cross section of the two light beams of the pump light 26. In the shown embodiment, the inner aperture 29 has an oval shape with a first diameter D 1 along a main axis and a second diameter D2 along a direction perpendicular to the main axis of the oval. The diameter D1 may, for example, be 102 mm. Diameter D2 may, for example, be 76 mm.

Advantageously, the shape of the obscuration structure 30 may reflect the aperture contour of the inner aperture 29. In the embodiment shown in Figure 4C, the obscuration structure 30 has an oval shape, resembling that of the aperture contour of the inner aperture 29.

The resulting irradiance I is shown in the lower part of Figure 4C. The resulting EUV power P is 101.6 % of the nominal power $P_N$.

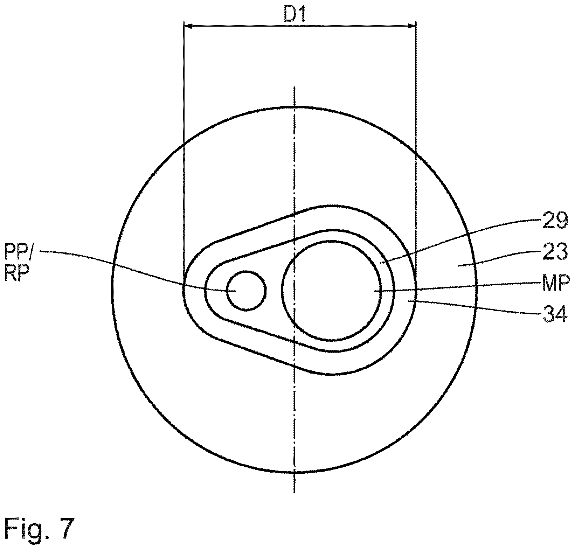

In Figure 7, a further embodiment of an inner aperture with an adapted aperture contour is shown. The embodiment takes advantage of the fact that a beam cross section of a light beam of the main pulse MP is larger than that of a light beam for the pre-pulse PP and the rarefaction pulse RP. Advantageously, the aperture contour of the inner aperture 29 not only reflects the relative position of different light beams, but also the respective beam cross section sizes. The dimension of the inner aperture 29 perpendicular to a main extension (being the maximum reflection surface aperture diameter D1) of the inner aperture 29 may vary. In the embodiment of Figure 7, the inner aperture 29 has an egg-shaped aperture contour. Preferably, also the shape of the obscuration structure is adapted to the aperture contour of the inner aperture 29.

In the above-discussed examples, the inner aperture 29 was directly formed within the collector substrate 32 of the EUV collector mirror 22. There are, however, many EUV collector mirrors of the current design, having a large aperture surface area. While it is possible to exchange existing EUV collector mirrors with the improved EUV collector mirrors 22 having the inner aperture 29 with reduced aperture surface area, such an exchange is costly. Hence, the present disclosure also foresees an inner aperture insert, which can be inserted in a main aperture of the EUV collector mirror, thereby reducing the size of the effective aperture for the pump light 26.

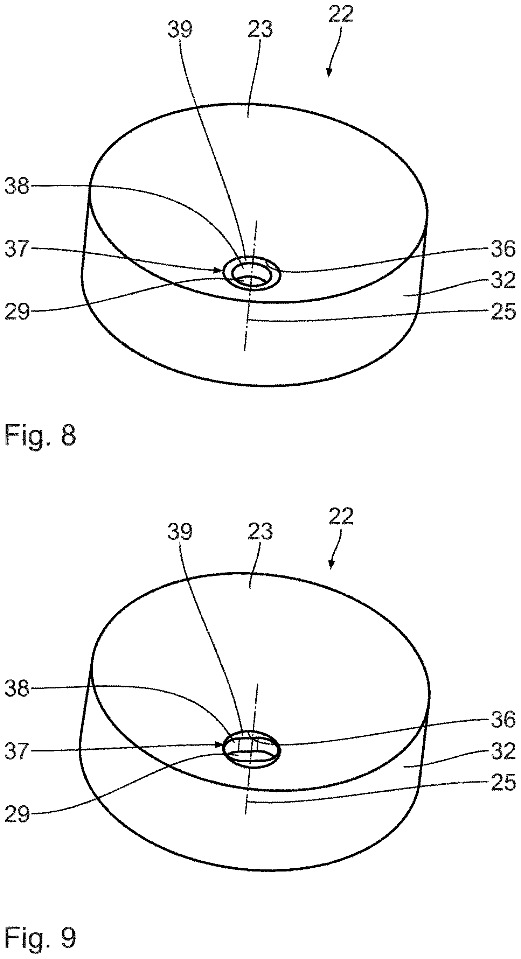

Figure 8 shows an embodiment of an EUV collector mirror 22 having a collector substrate 32 and a reflection surface 23. The EUV collector mirror 22, in particular its collector substrate 32, comprises a main aperture 36, whose diameter and surface area exceeds that of the inner aperture 29. For example, the main aperture 36 may be the inner aperture of the EUV collector, according to the current design, having a surface area larger than 1.4 % of a surface area of the collector surface. An aperture diameter of the main aperture 36 is larger than 85 mm.

An aperture insert 37 is inserted in the main aperture 36. The aperture insert 37 comprises a base body 38, in which the inner aperture 29 is provided. By way of the aperture insert 37, an effective surface area of an aperture for the pump light is decreased, thereby achieving the above-discussed advantages of decreasing the inner aperture surface area. The base body 38 comprises an EUV coating 39 on its surface facing the source region. EUV coating 39 serves to reflect EUV light, thereby contributing to the effective reflection surface 23 of the EUV collector mirror 22. EUV coating 39 may be a multilayer EUV coating, e.g. as described in WO 2014/108 256 A1 or WO 2013/045 311 A1.

The base body 38 of the aperture insert 37 preferably carries a pump light grating for reflecting incident pump light 26. An exemplary pump light grating structure is known from WO 2021/073 813 A1.

The aperture insert 38 may comprise alignment means for aligning the aperture insert relatively to the EUV collector mirror 22, in particular its collector substrate 32. The alignment means may also be used for fixing the aperture insert 37 in the main aperture 36. This is particularly useful for inner apertures 29, which do not have a circular aperture contour, so that the aperture contour can be aligned with respect to a beam cross section of one or more pump light beams. Suitable alignment means include, but are not limited to, alignment pins and/or alignment bodies, e.g. balls, which may interact with V-grooves. It is in particular possible to attach the aperture insert 37 directly to a purge nozzle, which may be arranged along an edge of the main aperture 36.

It is also possible that the aperture insert 37 comprises an insert purge nozzle, arranged circumferentially along the inner aperture 29 for jetting purge fluids on the EUV coating 39 of the aperture insert 37 and/or on the reflection surface 23 of the EUV collector mirror 22. For example, the insert purge nozzle of the aperture insert may be compatible with flow channels of a purging system of the EUV collector mirror 22.

Advantageously, the aperture insert 37 comprises heat dissipation components for conducting heat from the aperture insert 37 to the EUV collector mirror 22. The heat dissipation component may, for example, be formed by a thermally-conductive material extending preferably from an inner edge of the base body 38 to its circumference being in contact with the EUV collector mirror 22, in particular its collector substrate 32.

In the embodiment of Figure 8, the inner aperture 29 is circular. Of course, the inner aperture 29 configured according to any of the above-described examples for inner apertures, in particular comprising non-circular aperture contours.

Figure 9 shows a further embodiment of an EUV collector mirror 22 with an aperture insert 37 inserted in a main aperture 36. The inner aperture 29 of the aperture insert 37 has a non-circular, in this case oval, aperture contour. The orientation of the oval inner aperture 29, in particular with regard to the beam cross section of the pump light, may be ensured by suitable alignment means of the inner aperture insert 37.

The aperture contour of the inner aperture 29 of the aperture insert 37 differs from an outer contour of the base body 38.

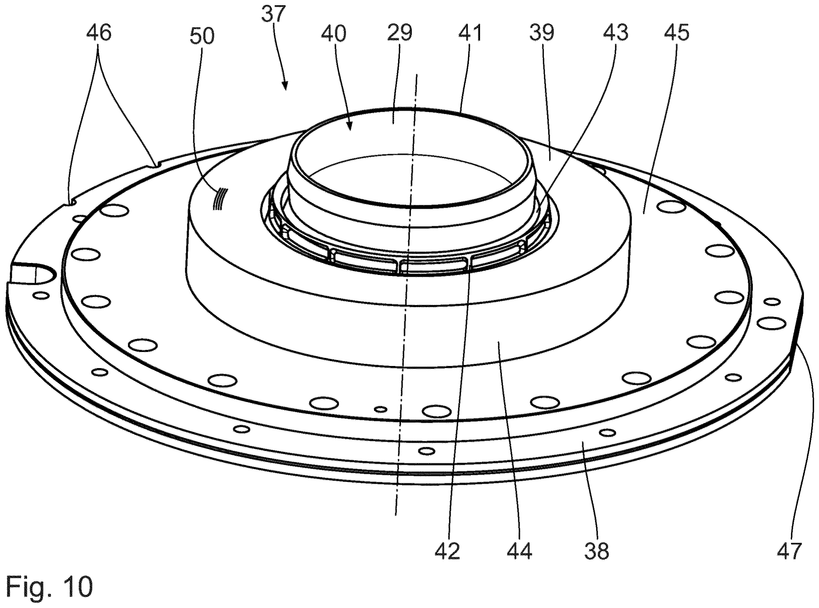

With regard to Figure 10, an exemplary embodiment of an aperture insert 37 is described. In the shown embodiment, the aperture insert has the circular shape of the inner aperture 29. The aperture insert 37 is configured to be inserted in a circular-shaped main aperture of the EUV collector mirror. The aperture insert 37 of Fig. 10 may, for example, be used in an EUV collector mirror 22 as shown in Fig. 8. Of course, also other shapes of the inner aperture 29 are possible, e.g. an oval shape as shown in the embodiment of Fig. 9.

The aperture insert 37 comprises a base body 38, to which a cone structure 40 is connected, in particular bolted. The cone structure 40 comprises an inner cone 41 defining the inner aperture 29 and an outer cone 42 circumferentially surrounding the inner cone 40. Between the inner cone 41 and the outer cone 42 an aperture purge nozzle 43 is formed for jetting purge fluids on an EUV coating 39 of the aperture insert 37 and/or an EUV coating of the reflection surface of the collector mirror. In the base body 38, purge fluid channels may be formed for providing purge fluids to the aperture purge nozzle 43. The purge fluid channels may connect to purge fluid channels of the EUV collector mirror, in particular of the main body of the EUV collector mirror.

The aperture insert 37 comprises a mirror segment having a mirror component 44, which is connected, in particular bolted, directly to the base body 38 and/or a base element 45 of the cone structure. The mirror component 44 is, in the present embodiment, ring-shaped and surrounds the cone structure 40. The mirror component 44 comprises an EUV coating 39. The mirror component 44 serves for reflecting EUV light in a region, in which the main aperture of the base body of the EUV collector mirror would otherwise allow the EUV light to pass the EUV collector mirror and leave the light source module.

In particularly advantageous embodiments, the mirror segment 44 may carry a pump light grating, which is schematically indicated at 50, for reflecting pump light. An exemplary pump light grating structure is known from WO 2021/073 813 A1.

As can be seen in Fig. 10, the aperture insert 37 comprises alignment means for aligning the aperture insert 37 relatively to the EUV collector mirror and/or a beam cross section of the pump light. For example, the base body 38 may comprise guide grooves 46 interacting with guide elements of the EUV collector mirror, stop surfaces 47 interacting with corresponding stop elements of the EUV collector mirror and/or further alignment elements, not explicitly shown in the figure. For example, the guide elements may comprise alignment pins and the like.

In the shown embodiment, the base element 45 of the cone structure 40 is in direct contact with the mirror component 44. The base element 45 may serve as a heat dissipation component for conducting heat away from the mirror component 44 towards the EUV collector mirror, e.g. its main body. Of course, such heat dissipation components may also be incorporated independent of a cone structure 40, e.g. by parts of the base body 38 being in contact with, in particular being bolted to, the mirror component 44.

**Claims**

1.  EUV collector mirror (22) for a light source module (2) having a collector surface having

    - a reflection surface (23) for reflecting usable EUV light, which impinges on the reflection surface (23) from a source region (24), to a subsequent EUV optics (6) and
    - an inner aperture (29) for pump light (26),

    wherein the inner aperture (29) has an aperture surface area which is smaller than 1.4 % of a surface area of the collector surface.

2.  EUV collector mirror (22) according to claim 1, wherein the aperture surface area is between 0.53 % and 1.4 % of the surface area of the collector surface.

3.  EUV collector mirror (22) according to claim 1 or 2, wherein the inner aperture (29) has an aperture diameter d, wherein $d \leq 85$ mm, in particular $53$ mm $\leq d \leq 85$ mm.

4.  EUV collector mirror (22) according to any one of the preceding claims, wherein an aperture contour of the inner aperture (29) is adapted to a beam cross section of one or more light beams of the pump light (26).

5.  EUV collector mirror (22) according to any one of the preceding claims, wherein the inner aperture (29) has an aperture contour, which is non-circular, in particular which has a two-fold or one-fold rotation symmetry.

6.  EUV collector mirror (22) according to any one of the preceding claims, wherein the collector surface comprises a main aperture (36) in the reflection surface (23), whose surface area exceeds that the aperture surface area of the inner aperture (29), and wherein the inner aperture is provided in an aperture insert (37), which is inserted in the main aperture (36).

7.  Light source module (2) for EUV light (3), having

    - a EUV collector mirror (22) as claimed in any one of the preceding claims and
    - one or more pump light sources (27) to produce pump light (26).

8. Light source module (2) according to claim 7, wherein an obscuration structure (30) is arranged between the source region (24) and the subsequent EUV optics (6) for shielding the EUV optics (6) from pump light (26), and wherein shape and/or size of the obscuration structure (30) is adapted to the inner aperture (29) of the EUV collector mirror (22).

9. Light source module (2) according to claim 7 or 8, having two or more pump light sources, wherein the light beams of the two or more pump light sources are aligned to coaxially pass through the inner aperture (29) of the EUV collector mirror. (22)

10. Illumination system for an EUV projection exposure apparatus (1) comprising

   - a light source module (2) according to any one of claims 7 to 9., and
   - an illumination optical unit (6) for guiding usable EUV illumination light (3) from light source module (2) towards an object field (4) in an object plane (5), in which an object to be imaged is arrangable.

11. Projection exposure apparatus (1) comprising

   - an illumination system according to claim 10, and
   - a projection optical unit (7) for imaging the object field (4) into an image field (8), in which a substrate (11) is arrangable.

12. Aperture insert (37) for an EUV collector mirror (22), in particular according to claim 6, wherein the aperture insert (37) comprises a base body (38) with an inner aperture (29) for pump light (29), and wherein the aperture insert (37) is configured to be inserted into a main aperture (36) of the EUV collector mirror (22), thereby reducing the size of the effective aperture for the pump light (22).

13. Aperture insert (37) according to claim 12, comprising mirror segment (44) for reflecting EUV light (3).

14. Aperture insert (37) according to claim 12 or 13, having a pump light grating for reflecting incident pump light (26).

15. Aperture insert (37) according to any one of claims 12 to 14, comprising alignment means for aligning the aperture insert (37) relatively to the EUV collector mirror (22) and/or a beam cross section of the pump light (26).

16. Aperture insert (37) according to any one of claims 12 to 15, comprising an aperture purge nozzle (43) arranged circumferentially the inner aperture for jetting purge fluids on an EUV coating (39) of the aperture insert (37) and/or a reflection surface (23) of the EUV collector mirror (22).

17. Aperture insert (37) according to any one of claims 12 to 16, comprising heat dissipation components for conducting heat from the aperture insert (37) to the EUV collector mirror (22).

18. Aperture insert (37) according to any one of claims 12 to 17, wherein an aperture contour of the inner aperture (29) differs from an outer contour of the base body (38).

19. Light source module (2) for EUV light, having

   - one or more pump light sources (27) to produce pump light (26),
   - an EUV collector mirror( 22) with

       -- a reflection surface (23) having a primary focus (PF) and an intermediate focus (IF) for reflecting usable EUV light, which impinges on the reflection surface (23) from a source region (24) around the primary focus (PF), to a subsequent EUV optics beyond the intermediate focus (IF), and
       -- an inner aperture (29) for the pump light (26),

   - an obscuration structure (30) for shielding the EUV optics from the pump light (26), and
   - a mounting rod (31) for mounting the obscuration structure (30) between the primary focus (PF) and the intermediate focus (IF), wherein the obscuration structure (30) is configured not to block any light path originating in the primary focus (PF) and being reflected by the reflection surface (23) towards the intermediate focus (IF).

20. Light source module (2) according to claim 19, wherein the size and/or shape of the obscuration structure (30) is adapted to a size and/or shape of the inner aperture (29) of the EUV collector mirror (22).

21. Light source module (2) according to claim 20, wherein the obscuration structure (30) has an obscuration structure contour, which corresponds to the aperture contour of the inner aperture (29).

22. Light source module (2) according to any one of claims 19 to 21, in particular according to claim 21, wherein the obscuration structure (30) has an obscuration structure contour, which is non-circular, in particular which has a two-fold or one-fold rotation symmetry.

23. Light source module (2) according to any one of claims 19 to 22,

wherein the EUV collector mirror (22) has an ellipsoidal shape with a semi-major axis a and a semi-minor axis b, wherein the obscuration structure (30) is positioned at a distance L from the primary focus (PF) of the EUV collector mirror (22), and wherein the diameter B of the obscuration structure (30) is chosen to be

$$B \leq B_{max}(D) = D\frac{2\,c - L}{c + a\sqrt{1 - D^2/(4b^2)}},$$

wherein $c = \sqrt{a^2 - b^2}$ and wherein D is a reflection surface aperture diameter associated with the inner aperture (29) of the EUV collector mirror (22).

24. Light source module (2) according to claim 23, wherein the following applies for the diameter B of the obscuration structure (30):

$$B_{min}(D) \leq B \leq B_{max}(D),$$

wherein $B_{min} = 0{,}75\,B_{max}$.

Fig. 1

Fig. 2

Fig. 3

Fig. 4A

Fig. 4B

Fig. 4C

Fig. 5

Fig. 6A

Fig. 6B

Fig. 6C

Fig. 7

Fig. 8

Fig. 9

Fig. 10

## EUROPEAN SEARCH REPORT

**Application Number**

EP 24 19 6201

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2009 047712 A1 (ZEISS CARL SMT GMBH [DE]) 16 June 2011 (2011-06-16) | 1,3,4,7, 9-11 | INV. G03F7/20 |
| Y | * paragraphs [0042] - [0045]; figure 1 * | 5,6 | H05G2/00 |
| A | | 2 | |
| | ----- | | |
| X | US 2013/161540 A1 (NAGAI SHINJI [JP] ET AL) 27 June 2013 (2013-06-27) | 12,15-21 | |
| Y | * paragraphs [0050] - [0055], [0060], | 6,8 | |
| A | [0061]; figures 1, 3A-F * | 13,14,24 | |
| | ----- | | |
| Y | US 2011/309260 A1 (NISHISAKA TOSHIHIRO [JP] ET AL) 22 December 2011 (2011-12-22) * paragraphs [0044] - [0047]; figure 4 * | 5 | |
| | ----- | | |
| X | "Research Disclosure", RESEARCH DISCLOSURE, KENNETH MASON PUBLICATIONS, HAMPSHIRE, UK, GB, vol. 593, no. 4, 29 July 2013 (2013-07-29) , page 6, XP007142484, ISSN: 0374-4353 | 19-23 | |
| Y | * the whole document * | 8 | **TECHNICAL FIELDS SEARCHED (IPC)** |
| A | | 24 | |
| | ----- | | G03F |
| A | US 2012/104290 A1 (NISHISAKA TOSHIHIRO [JP] ET AL) 3 May 2012 (2012-05-03) * paragraphs [0082] - [0085]; figures 1, 7 * | 1-24 | H05G |
| | ----- | | |

The present search report has been drawn up for all claims

| Place of search | Date of completion of the search | Examiner |
|---|---|---|
| Munich | 31 March 2025 | Eisner, Klaus |

Europäisches
Patentamt
European
Patent Office
Office européen
des brevets

**Application Number**

EP 24 19 6201

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

[X] All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**
**SHEET B**

Application Number

EP 24 19 6201

The Search Division considers that the present European patent application does not comply with the requirements of unity of invention and relates to several inventions or groups of inventions, namely:

```
1. claims: 1-7, 9-18

        EUV collector. light source module. illumination system.
        projection exposure apparatus
        Collector comprising inner aperture meeting certain
        constraints
                        ---


2. claims: 8, 19-24

        Light source module. Obscuration structure mounted between
        the primary focus and intermediate focus
                        ---
```

## ANNEX TO THE EUROPEAN SEARCH REPORT
## ON EUROPEAN PATENT APPLICATION NO.

EP 24 19 6201

This annex lists the patent family members relating to the patent documents cited in the above-mentioned European search report.
The members are as contained in the European Patent Office EDP file on
The European Patent Office is in no way liable for these particulars which are merely given for the purpose of information.

31-03-2025

| Patent document cited in search report | Publication date | Patent family member(s) | Publication date |
|---|---|---|---|
| DE 102009047712 A1 | 16-06-2011 | DE 102009047712 A1 | 16-06-2011 |
| | | WO 2011069881 A1 | 16-06-2011 |
| US 2013161540 A1 | 27-06-2013 | JP 2013135033 A | 08-07-2013 |
| | | US 2013161540 A1 | 27-06-2013 |
| US 2011309260 A1 | 22-12-2011 | EP 2548080 A1 | 23-01-2013 |
| | | JP 5670174 B2 | 18-02-2015 |
| | | JP 2011216851 A | 27-10-2011 |
| | | US 2011309260 A1 | 22-12-2011 |
| | | US 2014001369 A1 | 02-01-2014 |
| | | WO 2011115233 A1 | 22-09-2011 |
| US 2012104290 A1 | 03-05-2012 | JP 5758750 B2 | 05-08-2015 |
| | | JP 2012109218 A | 07-06-2012 |
| | | US 2012104290 A1 | 03-05-2012 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20190094699 A1
- DE 102019200698 A1
- WO 2021073813 A1
- DE 102009045096 A1
- DE 102012202675 A1
- WO 2014108256 A1
- WO 2013045311 A1